# FASCICULE DE BREVET EUROPEEN

(11) **EP 0 495 899 B1**
(45) Date de publication et mention de la délivrance du brevet: **14.12.1994**
(21) Numéro de dépôt: 90916130.9
(22) Date de dépôt: 15.10.1990
(51) Int. Cl.: H01L 27/20, G01L 9/00

(54) **CAPTEUR A SEMI-CONDUCTEURS**
HALBLEITERSENSOR
SEMICONDUCTOR SENSOR

(30) Priorité: 13.10.1989 FR 8913383
(43) Date de publication de la demande: 29.07.1992
(73) Titulaire: SCHLUMBERGER INDUSTRIES, F-92120 Montrouge (FR)
(72) Inventeur: MOSSER, Vincent, F-92170 Vanves (FR); SUSKI, Ian, F-92160 Antony (FR)
(86) Numéro de dépôt international: FR9000736
(87) Numéro de publication internationale: WO9106125

(56) Documents cités:
- EP-B- 0 040 795
- FR-A- 2 143 553
- GB-A- 2 011 707
- US-A- 3 492 861
- SENSORS AND ACTUATORS, volume 7, no. 3, July 1985, Lausanne, CH, pages 167-176 ; J. Neumeister et al. : "A Silicon Pressure Sensor Using MOS Ring Oscillators".

## Description

L'invention se situe dans le domaine des capteurs à éléments semi-conducteurs à effet de champ. Elle concerne plus particulièrement un capteur destiné à la mesure d'une grandeur physique telle que la pression, la contrainte, la déformation, la température, etc... , et réalisé sous la forme d'un oscillateur en anneau à partir de transistors MOSFET (metal-oxyde-semiconductors field-effect transistor).

Il est connu depuis fort longtemps que le silicium qui est le matériau de base pour la fabrication des transistors MOSFET présente des propriétés piézorésistives intéressantes pour le domaine des capteurs.

Est également connu, par exemple d'après le brevet EP-B-O, 040,795, un capteur à semi-conducteurs comprenant un nombre impair d'inverseurs CMOS (complementary metal-oxyde semiconductor) disposés dans une zone sensible à la pression et connectés entre eux pour former un oscillateur en anneau sensible à la pression. La fréquence de l'oscillateur ainsi obtenu est directement liée à la contrainte à laquelle les éléments semi-conducteurs sont soumis sous l'effet de la pression.

L'invention a pour objet un capteur à semi-conducteurs présentant une très bonne sensibilité, tout en maintenant un prix de revient relativement faible. Elle a également pour objet d'éliminer les dérives du capteur sous l'effet de la température et d'améliorer le rendement du processus de fabrication en réduisant le nombre de rebuts.

Le capteur selon l'invention comprend une plaquette de sicilium ayant une zone sensible à la grandeur physique à mesurer, telle que la pression, la contrainte, la déformation ou la température. Le capteur comprend au moins un oscillateur en anneau formé à partir d'un nombre impair d'inverseurs CMOS et disposé dans ladite zone sensible de manière à ce que la fréquence dudit oscillateur soit représentative de ladite grandeur physique; pour chaque inverseur CMOS, le canal n du transistor NMOS est sensiblement perpendiculaire au canal p du transistor PMOS.

Les propriétés piézorésistives anisotropes des transistors NMOS et PMOS sont connues. Mais, par exemple, l'article Sensors and Actuators, 7 (1985), pages 167-176 (en particulier les figures 1 et 2 et le texte correspondant) constate la supériorité des transistors PMOS et - en soulignant l'utilisation avantageuse des effets piézorésistifs longitudinal et transversal pour des applications pratiques - propose deux oscillateurs en anneau réalisés en transistors PMOS, tous les transistors de chaque oscillateur ayant des canaux parallèles et étant perpendiculaires à ceux de l'autre oscillateur (voir la figure 5 et page 175, "5.Conclusions"). Il n'y a donc aucune indication d'un arrangement perpendiculaire des transistors CMOS formant un étage particulier de l'oscillateur revendiqué.

L'arrangement de l'invention permet d'augmenter la sensibilité du capteur de l'ordre de 15 à 20% par rapport à une disposition parallèle.

La zone sensible peut notamment prendre la forme d'une membrane déformable; la grandeur physique que l'on désire mesurer est alors la pression.

Selon divers modes particuliers de réalisation, le capteur comprend au moins un couple de deux oscillateurs en anneau de manière à réduire les dérives du capteur liées aux variations de température.

Selon un mode de réalisation particulièrement avantageux, la zone sensible du capteur est munie de plusieurs couples d'oscillateurs en anneau, de façon à réduire le nombre de rebuts au cours du processus de fabrication.

Pour éliminer plus complètement l'influence d'une grandeur physique parasite, telle que la température, le capteur peut également être muni d'au moins un oscillateur supplémentaire qui est uniquement sensible à cette grandeur physique parasite et qui de ce fait sert de référence.

La description qui suit, donnée à titre d'exemple, est illustrée par les figures jointes en annexe qui représentent:

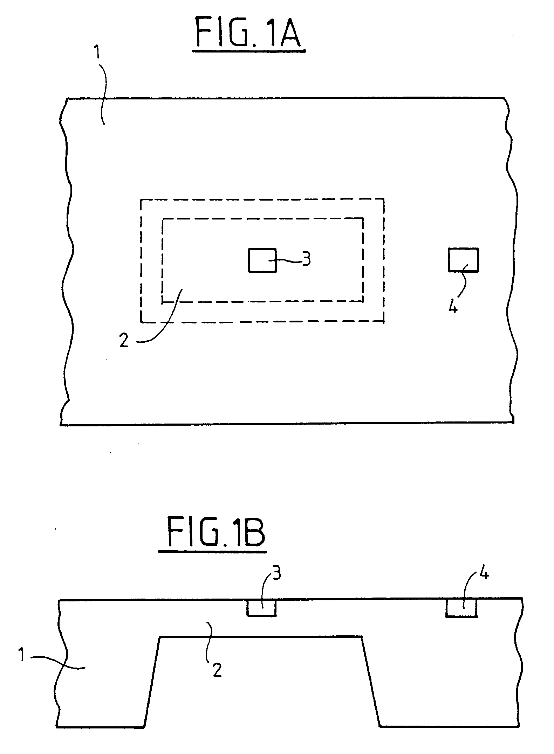

- les figures 1A et 1B respectivement en vue de dessus et une coupe d'un premier mode de réalisation correspondant à un capteur de pression;

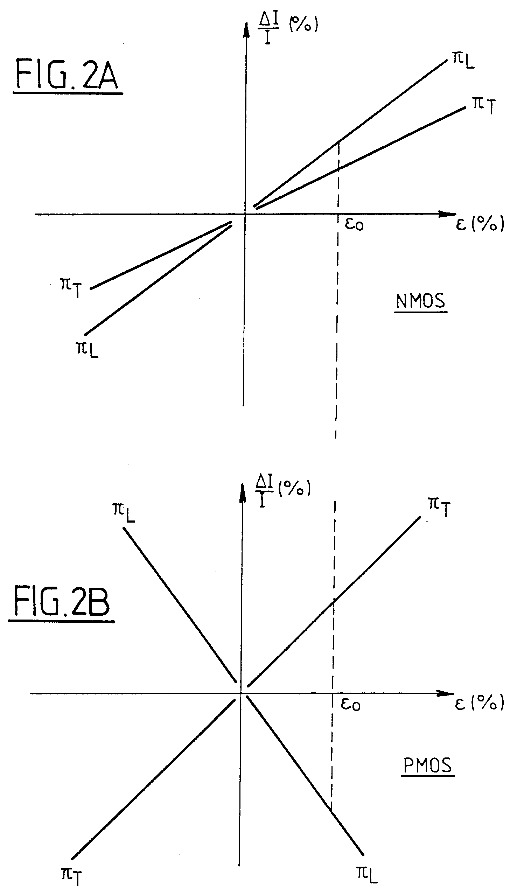

- les figures 2A et 2B les diagrammes respectifs représentant les coefficients piézorésistifs des transistors NMOS et PMOS;

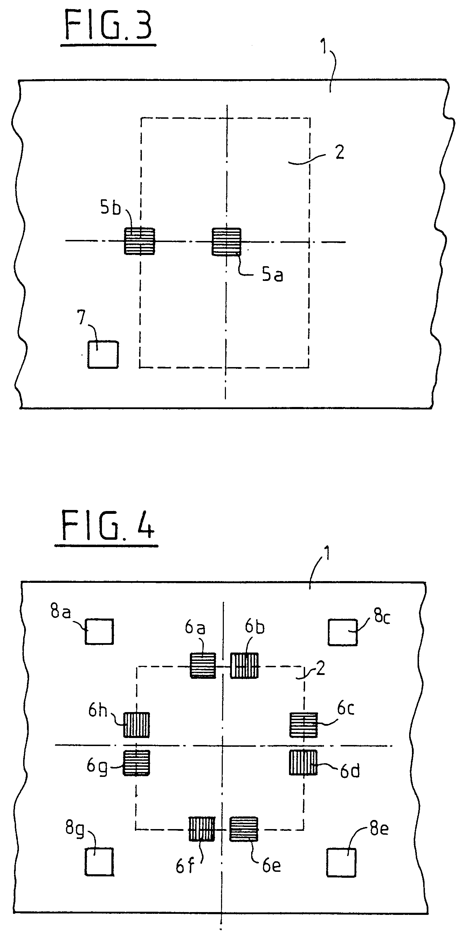

- la figure 3 une vue de dessus d'un second mode de réalisation pour un capteur de pression comprenant un couple de deux oscillateurs en anneau; et
- la figure 4 une vue de dessus d'un troisième mode de réalisation comprenant quatre couples de deux oscillateurs en anneau.

Le capteur selon l'invention est réalisé à partir d'une plaquette de silicium comprenant une zone sensible à la grandeur physique que l'on désire mesurer; pour les modes de réalisations particuliers décrits ci-après, cette zone est formée par une membrane sensible à la pression. On imaginera facilement que la zone sensible peut également être la surface d'une simple poutre et que la grandeur physique que l'on désire mesurer est une contrainte ou encore une déformation.

Selon un premier mode de réalisation représenté aux figures 1A et 1B, la plaquette de silicium 1 orientée selon le plan (100) comprend une membrane 2 de forme rectangulaire sensible à la pression, au centre de laquelle est disposé un oscillateur en anneau 3. L'oscillateur 3 comprend un nombre impair d'inverseurs CMOS, par exemple 89 ce qui donne une fréquence d'oscillation de l'ordre du mégahertz. En ce qui concerne le circuit d'un oscillateur en anneau, tel que l'oscillateur 3, on pourra notamment se reporter au livre "Mc MOS Handbook" de Motorola Inc, Semiconductor Products Division, 1973, Chap. 8, "Analog Basic Circuits". On pourra également se reporter à l'ouvrage intitulé "Dispositifs et circuits intégrés semiconducteurs" de A. Vapaille et R. Castagné, 1987 (pages 453 et 454) en ce qui concerne la réalisation d'un inverseur en technologie CMOS.

Chaque inverseur CMOS est formé d'au moins un transistor NMOS et d'au moins un transistor PMOS, le canal n du transistor NMOS étant aligné selon l'axe cristallographique [110] et le canal p du transistor PMOS étant aligné selon l'axe [11̅0], de manière à ce que le canal n soit perpendiculaire au canal p.

Les travaux entrepris par la demanderesse ont permis de montrer que lorsque le canal n est perpendiculaire au canal p, c'est à dire par exemple le canal n suivant un axe longitudinal [110] et le canal p suivant un axe transversal [11̅0] ou vice versa, on obtient un accroissement de la sensibilité du capteur de l'ordre de 15 à 20% par rapport à une implantation parallèle.

Cette augmentation de sensibilité peut trouver une explication en se reportant aux figures 2A et 2B qui illustrent respectivement pour les transistors NMOS et PMOS, l'effet piézorésistif, c'est à dire la variation du courant ΔI/I traversant le transistor en fonction de la déformation ε . On notera tout particulièrement que l'effet piézorésistif est fortement dépendant d'une part du type du transistor, et d'autre part qu'il est anisotrope du fait de la différence existant entre les coefficients de piézorésistivité ΠL et ΠT, respectivement pris selon des axes longitudinal [110] et transversal [11̅0] du plan (100) du cristal de silicium. Ce dernier ayant une structure cristallographique cubique, on pourra naturellement aussi bien transposer cette analyse à la famille des plans (100) associés à la famille des axes cristallographiques <110>.

Pour une déformation ε o donnée, la réponse de l'inverseur CMOS correspond sensiblement à la somme des réponses pour les transistors NMOS et PMOS. Que cette déformation soit positive ou négative, c'est à dire sous la forme d'une élongation ou d'une compression, on s'aperçoit que la somme algébrique des réponses des deux transistors NMOS et PMOS est supérieure dans le cas où l'un des deux transistors est soumis à une contrainte longitudinale et l'autre à une contrainte transversale, que dans le cas où les deux transistors sont soumis conjointement soit à une contrainte longitudinale, soit à une contrainte transversale.

Le premier mode de réalisation décrit en référence aux figures 1A et 1B présente cependant un inconvénient dans la mesure où la fréquence délivrée par l'oscillateur est fortement dépendante de la température de la membrane.

Pour remédier à cet inconvénient, on peut faire appel à diverses solutions. Parmi ces dernières, l'une consiste à ajouter un second oscillateur 4, dit oscillateur de référence, sensiblement identique à l'oscillateur 3 et disposé dans une zone qui n'est pas soumise à la grandeur physique que l'on désire mesurer, en l'occurence la pression; la fréquence délivrée par l'oscillateur 4 est directement liée à la température de la plaquette de silicium 1 et de ce fait l'oscillateur 4 constitue un capteur de température. En traitant judicieusement les signaux obtenus à partir des fréquences délivrées par les oscillateurs 3 et 4, par exemple en faisant le rapport de ces deux fréquences, on obtient un signal représentatif de la pression et indépendant de la température.

Une autre solution consiste à disposer deux oscillateurs sur la membrane même; cette seconde solution peut s'envisager sous la forme de deux autres modes de réalisation, respectivement désignés ci-après deuxième et troisième modes de réalisation.

Selon le second mode de réalisation représenté à la figure 3, les deux oscillateurs 5a et 5b sont parallèles entre eux, c'est à dire que les canaux n et p de l'oscillateur 5a sont respectivement parallèles aux canaux n et p de l'oscillateur 5b, et sont respectivement disposés l'un au centre de la membrane 2 et l'autre sensiblement à la périphérie de la membrane 2; étant donné que les contraintes dans ces deux emplacements sont sensiblement égales mais de signe opposé, on observera, sous l'effet de la contrainte, un accroissement de la fréquence pour l'un des deux oscillateurs et une diminution de la fréquence pour l'autre oscillateur; En faisant le rapport des deux fréquences ainsi obtenues, on diminue très sensiblement l'influence de la mesure à la température.

D'une manière similaire à ce qui a été décrit en référence au premier mode de réalisation, on peut également ajouter un troisième oscillateur en anneau 7, dit oscillateur de référence, sensiblement identique aux oscillateurs 3 et 4 et disposé en dehors de la membrane 7 sensible à la pression. L'oscillateur 7 constitue donc un capteur de température qui permet, grâce à un traitement numérique approprié qui est à la portée de l'homme du métier, de complètement compenser la mesure de pression pour les variations de température.

Le troisième mode de réalisation représenté à la figure 4 correspond au mode préféré de réalisation. Les deux oscillateurs 6a et 6b sont perpendiculaires entre eux et disposés côte à côte dans une zone située sensiblement à la périphérie de la membrane 2. En d'autres termes, les canaux n et p de l'oscillateur 6a sont respectivement perpendiculaires aux canaux n et p de l'oscillateur 6b. En faisant le rapport des fréquences délivrés par les deux oscillateurs, on élimine pratiquement la dérive en température.

Une amélioration possible consiste à disposer quatre couples de deux oscillateurs (6a;6b), (6c;6d), (6e;6f) et (6g;6h) selon les quatres côtés d'une membrane carrée. Si pour des raisons liées à la fabrication il s'avérait qu'un, voire deux ou même trois couples d'oscillateurs soient défaillants, il resterait toujours un quatrième couple d'oscillateurs pour former le capteur. Cette amélioration, de par son caractère de redondance, a pour effet d'augmenter très sensiblement le rendement du processus de fabrication; de plus, elle est très avantageuse puisque le coût de fabrication est généralement fonction de la surface de la plaquette de silicium traitée.

Une autre amélioration possible, similaire à celle décrite en référence aux deux premiers modes de réalisation, consiste à ajouter un ou plusieurs oscillateurs 8a, 8c, 8e et 8g disposés en dehors de la membrane sensible à la pression et destinés à mesurer la température de manière à corriger les dérives résiduelles en température.

## Revendications

1. Capteur à semi-conducteurs pour mesurer une grandeur physique, telle que la pression, la contrainte, la déformation ou la température, comportant une plaquette de silicium ayant une zone sensible (2) à la grandeur physique, ce capteur comprenant au moins un oscillateur en anneau (3) formé par un nombre impair d'inverseurs CMOS, disposé dans ladite zone sensible de manière à ce que la fréquence dudit oscillateur soit représentative de ladite grandeur physique, caractérisé par le fait que pour chaque inverseur CMOS, le canal n du transistor NMOS est sensiblement perpendiculaire au canal p du transistor PMOS.

2. Capteur selon la revendication 1, caractérisé par le fait que ladite zone sensible (2) est une membrane et que ladite grandeur physique est une pression.

3. Capteur selon la revendication 2, caractérisé par le fait qu'il comprend deux oscillateurs en anneau (5a, 5b) orientés parallèlement l'un par rapport à l'autre, l'un (5a) des deux oscillateurs étant disposé au centre de la membrane, tandis que l'autre (5b) est disposé sensiblement à la périphérie de la membrane.

4. Capteur selon la revendication 2, caractérisé par le fait qu'il comprend au moins un couple de deux oscillateurs en anneau (6a, 6b) disposés côte à côte sensiblement à la périphérie de la membrane et orientés perpendiculairement l'un par rapport à l'autre.

5. Capteur selon la revendication 4, caractérisé par le fait que la membrane (2) est sensiblement carrée.

6. Capteur selon la revendication 5 caractérisé par le fait qu'il comprend quatre couples d'oscillateurs (6a, 6b; 6c, 6d; 6e, 6f; 6g, 6h) respectivement disposés sur les quatres côtés de la membrane carrée (2).

7. Capteur selon l'une des revendications précédentes, caractérisé par le fait qu'il comprend en outre au moins un oscillateur en anneau (4; 7; 8a, 8c, 8e, 8g) disposé dans une zone qui n'est pas sensible à ladite grandeur physique que l'on désire mesurer et qui sert d'oscillateur de référence.

## Patentansprüche

1. Halbleitersensor zum Messen einer physikalischen Größe wie des Drucks, der Belastung, der Verformung oder der Temperatur mit einem Siliciumplättchen, das eine gegenüber der physikalischen Größe empfindliche Zone (2) aufweist, wobei dieser Sensor wenigstens einen Ringoszillator (3) aufweist, der durch eine ungerade Zahl von CMOS-Invertern gebildet ist und in der empfindlichen Zone so angeordnet ist, daß die Frequenz des Oszillators für die physikalische Größe steht, dadurch gekennzeichnet, daß der n-Kanal des NMOS-Transistors für jeden CMOS-Inverter im wesentlichen senkrecht zu dem p-Kanal des PMOS-Transistors liegt.

2. Sensor nach Anspruch 1, dadurch gekennzeichnet, daß die empfindliche Zone (2) eine Membran ist und die physikalische Größe ein Druck ist.

3. Sensor nach Anspruch 2, dadurch gekennzeichnet, daß er zwei Ringoszillatoren (5a, 5b) aufweist, die parallel zueinander orientiert sind, wobei einer (5a) der beiden Oszillatoren im Zentrum der Membran angeordnet ist, während der andere (5b) im wesentlichen am Umfang der Membran angeordnet ist.

4. Sensor nach Anspruch 2, dadurch gekennzeichnet, daß er wenigstens ein Paar von zwei Ringoszillatoren (6a, 6b) aufweist, die im wesentlichen am Umfang der Membran nebeneinander angeordnet und senkrecht zueinander orientiert sind.

5. Sensor nach Anspruch 4, dadurch gekennzeichnet, daß die Membran (2) im wesentlichen viereckig ist.

6. Sensor nach Anspruch 5, dadurch gekennzeichnet, daß er vier Paare von Oszillatoren (6a, 6b; 6c, 6d; 6e, 6f; 6g, 6h) aufweist, die an den vier Seiten der viereckigen Membran (2) angeordnet sind.

7. Sensor nach einem der vorhergehenden Ansprüche, dadurch gekennzeichnet, daß er ferner wenigstens einen Ringoszillator (4; 7; 8a, 8c, 8e, 8g) aufweist, der in einer Zone angeordnet ist, die nicht gegenüber der physikalischen Größe empfindlich ist, die gemessen werden soll, und der als Referenzoszillator dient.

## Claims

1. A semiconductor sensor for measuring a physical magnitude, such as pressure, constraint, deformation or temperature, comprising a silicium plate having a zone (2) sensitive to the physical magnitude, this sensor comprising at least one ring oscillator (3) constituted by an odd number of CMOS inverters, the oscillator being disposed in said sensitive zone in such a manner that the frequency of said oscillator is representative of said physical magnitude, characterized in that for each of the CMOS inverters, the n channel of the NMOS transistor is substantially perpendicular to the p channel of the PMOS transistor.

2. A sensor according to claim 1, characterized in that said sensitive zone (2) is a membrane and said physical magnitude is pressure.

3. A sensor according to claim 2, characterized in that it comprises two ring oscillators (5a, 5b) oriented in parallel with each other, one (5a) of the two oscillators being disposed in the center of the membrane while the other (5b) is disposed substantially at the periphery of the membrane.

4. A sensor according to claim 2, characterized in that it comprises at least one pair of ring oscillators (6a, 6b) disposed side by side substantially at the periphery of the membrane and oriented perpendicularly relative to each other.

5. A sensor according to claim 4, characterized in that the membrane (2) is substantially square.

6. A sensor according to claim 5, characterized in that it comprises four pairs of oscillators (6a, 6b; 6c, 6d; 6e, 6f; 6g, 6h) disposed respectively on the four sides of the square membrane (2).

7. A sensor according to any of the preceding claims, characterized in that it further includes at least one ring oscillator (4; 7; 8a, 8c, 8e, 8g) disposed in a zone which is not sensitive to said physical magnitude to be measured and which serves as a reference oscillator.
